# EUROPEAN PATENT SPECIFICATION

(11) **EP 2 187 709 B1**
(45) Date of publication and mention of the grant of the patent: **21.03.2018**
(21) Application number: 08830347.4
(22) Date of filing: 04.09.2008
(51) Int. Cl.: H05B 33/10, C23C 14/12, H01L 51/50, C23C 14/24, C23C 14/22

(54) **VAPOR EMISSION DEVICE, ORGANIC THIN-FILM VAPOR DEPOSITION APPARATUS AND METHOD OF ORGANIC THIN-FILM VAPOR DEPOSITION**
DAMPFEMISSIONSVORRICHTUNG, VORRICHTUNG ZUR ABLAGERUNG EINES ORGANISCHEN DÜNNFILMDAMPFS UND VERFAHREN ZUR ABLAGERUNG EINES ORGANISCHEN DÜNNFILMDAMPFS
DISPOSITIF D'ÉMISSION DE VAPEUR, APPAREIL DE DÉPÔT EN PHASE VAPEUR DE COUCHES MINCES ORGANIQUES ET PROCÉDÉ DE DÉPÔT EN PHASE VAPEUR DE FILMS MINCES ORGANIQUES

(30) Priority: 10.09.2007 JP 2007234441; 19.11.2007 JP 2007299139; 25.02.2008 JP 2008043480
(43) Date of publication of application: 19.05.2010
(73) Proprietor: Ulvac, Inc., Chigasaki-shi Kanagawa 253-8543 (JP)
(72) Inventor: NEGISHI, Toshio, Chigasaki-shi Kanagawa 253-8543 (JP); KOSHIDA, Tatsuhiko, Chigasaki-shi Kanagawa 253-8543 (JP)
(74) Representative: Körber, Martin Hans
(86) International application number: PCT/JP2008/065986
(87) International publication number: WO 2009/034916

(56) References cited:
- EP-A1- 1 741 802
- JP-A- 2004 214 185
- JP-A- 2005 330 537
- JP-A- 2006 152 326
- JP-A- 2006 249 541
- JP-A- 2007 070 679
- US-A1- 2006 137 607
- US-A1- 2007 054 051
- US-A1- 2007 098 891

## Description

### TECHNICAL FIELD

The present invention generally relates to a technology for organic thin film vapor deposition in order to form a luminescent layer of, for example, organic EL element.

### BACKGROUND ART

Conventionally, a vacuum deposition apparatus has been used to form a luminescent layer of organic EL element. For such a type of vacuum deposition apparatus for conducting efficient deposition on a number of substrates, an evaporation source having a linear and long evaporation vessel, with evaporation orifices provided along the length thereof and faced toward the horizontal direction, has been proposed, for example in JP-A-2002-249868. Such a type of evaporation source that uses a linear vessel is, however, required to continuously evaporate large amounts of organic material, which results in causing problems due to the decrease in efficiency in the use of the evaporation material, time-degradation and decomposition of the evaporation material, or the like.

On the other hand, evaporation source in the shape of a shower plate, has also been proposed. Furthermore, US 2007/098891 shows an evaporation shower head having cooling and heating means. Shower heads with a plurality of holes and heating or cooling means are well-known for CVD processes, see for example US 2006/137607.

### DISCLOSURE OF THE INVENTION

### PROBLEMS TO BE SOLVED BY THE INVENTION

The present invention has been made in view of the above-discussed conventional technical problems, and has for its object to provide a technology for organic material vapor deposition, which can enhance the efficiency in the use of evaporation material and can prevent the evaporation material from time-degradation.

### MEASURES TO SOLVE THE PROBLEMS

The present invention which achieves the above-explained object is a vapor emission device that has: an emission part in the shape of a shower-plate configured so as to be heatable and having a plurality of emission orifices arranged within a plane thereof for emitting a vapor of an organic evaporation material;a feeding part provided inside the emission part to feed the vapor of the organic evaporation material thereinto, and having a blowout orifice configured so as to spray the vapor of the organic evaporation material against an inner wall of the emission part; and a cooling means provided at least in a position on the emission orifice side of the emission part.

According to the present invention, the cooling means of the vapor emission device is to be formed so as to cover the entire emission part.

According to the present invention, the cooling means of the vapor emission device is also able to have a vapor passage hole that allows the vapor of the organic evaporation material to pass therethrough, in a position corresponding to the emission orifice of the emission part.

According to the present invention, the vapor emission device is also effective when the emission orifice of the emission part is formed at the tip of a nozzle part provided at the emission part; and the tip of the nozzle part is located in a position inside the vapor passage hole of the cooling means.

The present invention is directed to an organic thin film vapor deposition apparatus which deposits an organic thin film to a vapor deposition object in a vacuum via a mask is also effective when the apparatus includes:a vacuum tank for deposition capable of carrying the vapor deposition object thereinto; and a vapor emission device provided in the vacuum tank, the vapor emission device including:an emission part in the shape of a shower-plate configured so as to be heatable and having a plurality of emission orifices arranged within a plane thereof for emitting a vapor of an organic evaporation material;a feeding part provided inside the emission part for feeding the vapor of the organic evaporation material thereinto, and having a blowout orifice configured so as to spray the vapor of the organic evaporation material against an inner wall of the emission part; and a cooling means provided at least in a position on the emission orifice side of the emission part, wherein the emission orifices of the emission part are arranged so as to face the mask.

The present invention is directed to a method for depositing organic thin film which deposits an organic thin film to a vapor deposition object in a vacuum via a mask. The method includes the step of feeding an evaporation material, with the use of an emission part in the shape of a shower-plate having a plurality of emission orifices arranged within a plane thereof, by spraying a vapor of an organic evaporation material in the emission part against an inner wall thereof while heating the emission part, wherein heat transfer from the emission part toward the mask may be blocked by interposing a cooling means between the emission part and the mask in the step of feeding an evaporation material.

The present invention allows the vapor of the organic evaporation material to be fed at an optimum amount as needed, and thereby can prevent time-degradation and decomposition of the evaporation material even in the case of continuous deposition for a long period of time.

In addition, the present invention can control the temperature of the vapor which is emitted from the emission part without depositing the organic material inside the emission part.

Furthermore, the present invention provides a cooling means at least in a position on the emission orifice side of the emission part so as to block the heat transfer from the emission part toward the mask during vapor deposition, which can prevent the mask from deformation by heating during the vapor deposition.

In the present invention, when the cooling means is formed so as to cover the entire emission part, the quantity of heat transfer from the emission part toward the mask can be reduced, which can prevent the mask deformation by the heat generated at the vapor deposition in a more convincing way.

In the present invention, when the cooling means has vapor passage holes that allow the vapor of the organic evaporation material to pass therethrough, at positions corresponding to the respective emission orifices of the emission part, deformation of the mask is prevented by heat at the vapor deposition while the vapor of the organic material is emitted against the vapor deposition object in a sufficient quantity.

In this case, when the emission orifice of the emission part is formed at the tip of a nozzle part provided at the emission part and the tip of the nozzle part is located inside the vapor passage hole of the cooling means, the vapor of the organic evaporation material emitted from the emission orifice of the emission part does not adhere to the edge of the vapor passage hole of the cooling means during the vapor deposition; and a constant quantity of the vapor of the organic material can be smoothly guided toward the vapor deposition object.

### EFFECTS OF THE INVENTION

The present invention can provide a technology for organic material vapor deposition, which can improve the efficiency in the use of evaporation material and can prevent the evaporation material from time-degradation.

The present invention can also prevent a mask from deformation by heat during vapor deposition in a convincing way.

### BRIEF DESCRIPTION OF THE DRAWINGS

Fig. 1 is a schematic configuration diagram illustrating a perspective view of the principal part of an organic thin film vapor deposition apparatus used in an embodiment of the present invention.
Fig. 2 is a schematic internal configuration diagram illustrating the relationship a cross-sectional view of the principal part of the organic thin film vapor deposition apparatus.
Fig. 3 is an explanatory plan view illustrating the relationship between the emission orifices of the emission part and the vapor passage holes of the cooling means in the organic thin film vapor deposition apparatus.
Fig. 4 is an explanatory cross-sectional view illustrating the vapor deposition actions of the organic thin film vapor deposition apparatus.
Fig. 5 is a schematic internal configuration diagram illustrating a cross-sectional view of an evaporation chamber and a feeding means.

### Explanation of Reference Numerals

- 1: organic thin-film vapor deposition apparatus
- 2: vacuum tank
- 3: vapor-feeding part
- 3a, 3b, 3c: feeding means
- 10: vapor emission device
- 11: emission part
- 12: emission orifice
- 14: feeding pipe (feeding part)
- 14a: main body
- 15: blowout orifice
- 16: heater
- 17: cooling means
- 17a: vapor passage hole
- 20: substrate (vapor deposition object)
- 21: mask
- 50: vapor of organic evaporation material

### DETAILED DESCRIPTION OF THE PREFERED EMBODIMENTS

### BEST MODE FOR CARRYING OUT THE INVENTION

An embodiment of the present invention will be described in detail with reference to the drawings.

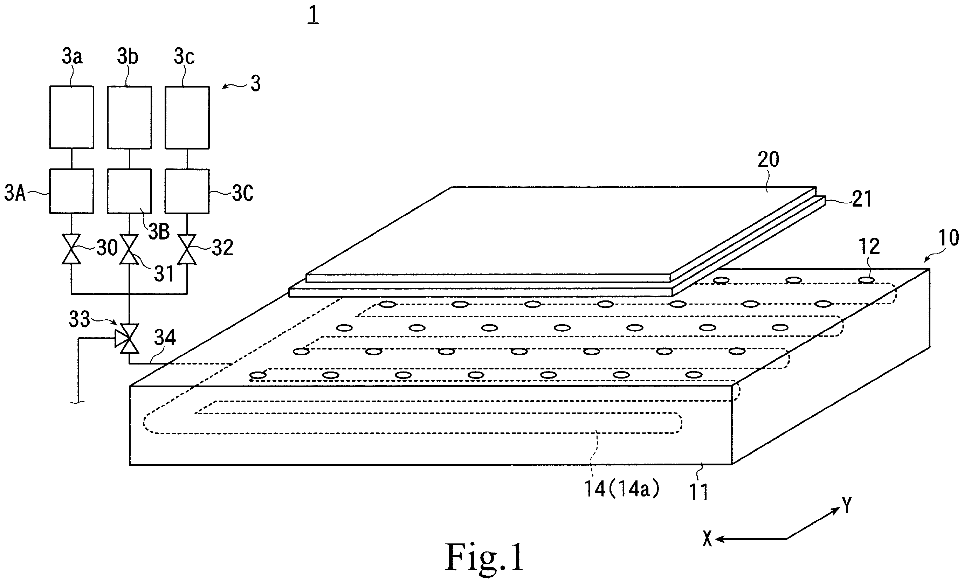

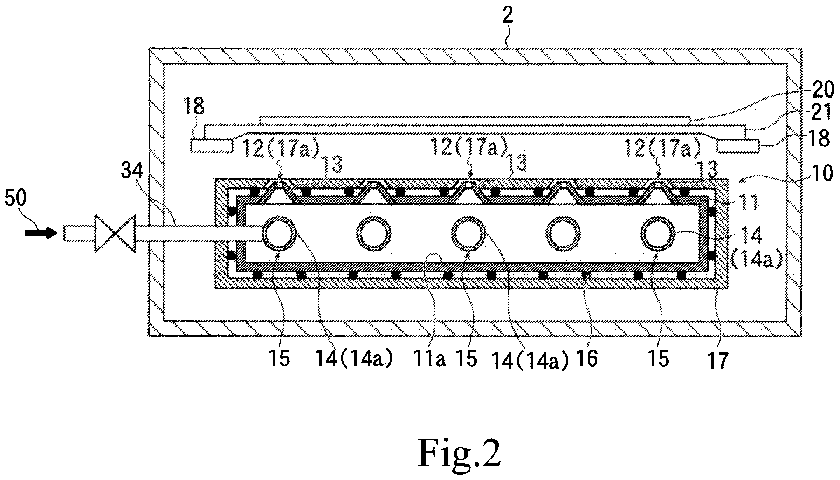

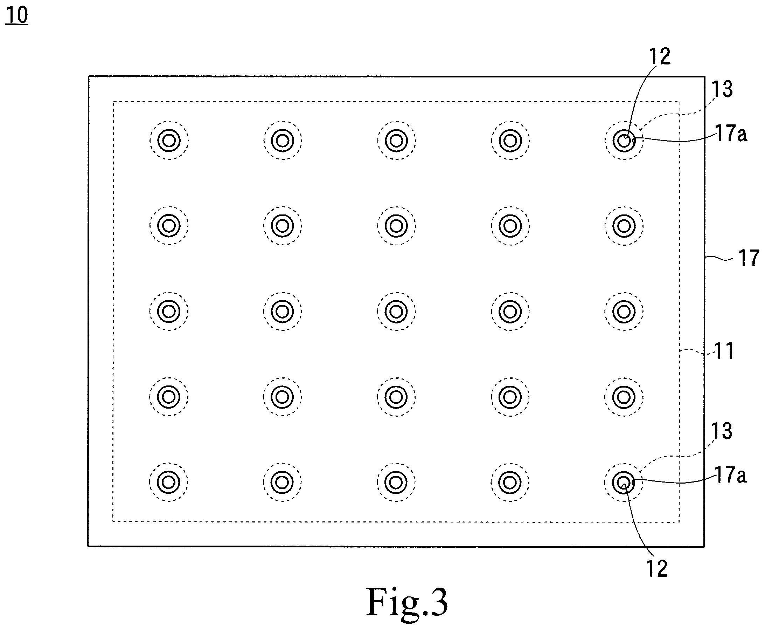

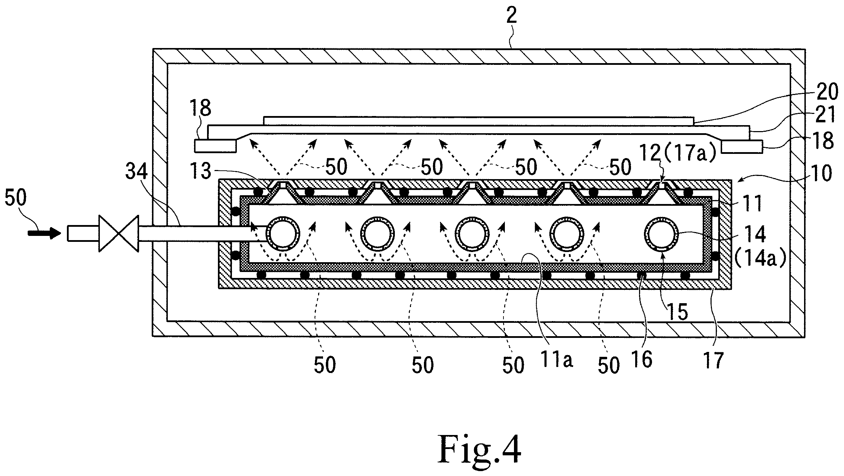

Fig. 1 is a schematic configuration diagram illustrating a perspective view of the principal part of an organic thin film vapor deposition apparatus used in an embodiment of the present invention; Fig. 2 is a schematic internal configuration diagram illustrating the relationship a cross-sectional view of the principal part of the organic thin film vapor deposition apparatus; Fig. 3 is an explanatory plan view illustrating the relationship between the emission orifices of the emission part and the vapor passage holes of the cooling means in the organic thin film vapor deposition apparatus; and Fig. 4 is an explanatory cross-sectional view illustrating the vapor deposition actions of the organic thin film vapor deposition apparatus.

As illustrated in Fig. 1 and Fig. 2, an organic thin film vapor deposition apparatus 1 of the embodiment has a vacuum tank 2 which is connected to an evacuation system (not shown) and has a vapor emission device 10. The apparatus 1 also has a vapor-feeding part 3, which supplies vapor of the organic evaporation material into the vacuum tank 2.

The vapor-feeding part 3 of the embodiment has a plurality of feeding means 3a, 3b and 3c, and a plurality of evaporation chambers 3A, 3B and 3C, which are connected to the feeding means 3a, 3b and 3c, respectively, and also connected to the evacuation system (not shown).

Each of the feeding means 3a, 3b and 3c supplies a particulate organic evaporation material for forming an organic layer of an organic EL device to each of the evaporation chambers 3A, 3B and 3C, in a predetermined quantity.

The vapor of the organic evaporation material evaporated in each of the evaporation chambers 3A, 3B and 3C is guided to the vapor emission device 10 via an inlet pipe 34 by switching respective valves 30, 31, 32 and 33.

The supply of vapor of the organic evaporation material from each of the evaporation chambers 3A, 3B and 3C to the vapor emission device 10 is performed by making the internal pressure of the vacuum tank 2 lower than the internal pressure of the respective evaporation chambers 3A, 3B and 3C.

As illustrated in Fig. 2, a substrate 20 which is a vapor deposition object and a mask 21 are integrally carried into the vacuum tank 2. In this embodiment, the mask 21 is disposed in the vacuum tank 2 facing toward the vapor emission device 10.

The vapor emission device 10 of the embodiment has an emission part 11 formed of, for example, a housing in the shape of substantially a plate which is substantially a rectangular parallelepiped.

The emission part 11 is made of, for example, a metallic material, and has a plurality of emission orifices 12 on a plane facing the substrate 20.

In this embodiment, a plurality of nozzle parts 13 in the shape of a truncated cone is provided in the upper part of the emission part 11 in the vertically upward direction; i.e., in a direction facing the substrate 20. An emission orifice 12 in the shape of, for example, a circle is formed at the tip of the nozzle part 13.

A feeding pipe (feeding part) 14 is provided inside the emission part 11.

The feeding pipe 14 is connected to the foregoing inlet pipe 34, and has a plurality of main body 14a in the shape of, for example, a cylindrical pipe extending linearly in the X-axis direction of Fig. 1 provided at predetermined intervals in the internal space of the emission part 11.

At a lower part of the main body 14a of the feeding pipe 14, a plurality of blowout orifices 15 to guide the vapor of the organic evaporation material into the emission part 11 is provided at predetermined intervals.

According to this embodiment, each of the blowout orifices 15 are disposed directly beneath the feeding pipes 14 so that each of the blowout orifices 15 faces a bottom part (inner wall) 11a of the emission part 11.

A heater 16 of, for example, a resistance-heating type is provided on the outer surface of the emission part 11. The heater 16 is wound around the outer surface of the emission part 11, and is connected to a power source (not shown).

In addition, a cooling means 17 made of a thermal insulation material is provided around the heater 16.

The cooling means 17 circulates a cooling medium (not shown). The cooling means 17 covers the entire emission part 11 to prevent the heat of the heater 16 from transferring to the mask 21.

As illustrated in Fig. 2 and Fig. 3, in the upper (top)part of the cooling means 17 in positions corresponding to each of the emission orifices 12 of the emission part 11, vapor passage holes 17a in the shape of, for example, a circle, which ensures a smooth emission of the vapor of the evaporation material.

According to this embodiment, the diameter of the respective vapor passage hole 17a is larger than that of the emission orifice 12 of the emission part 11. Furthermore, the tip of each of the nozzle parts 13 is disposed in a position, inside each of the vapor passage holes 17a of the cooling means 17, where the tip of the nozzle parts does not protrude from each of the vapor passage holes 17a.

With the above-described structural arrangement, during vapor deposition, vapor 50 of organic evaporation material emitted from the emission orifices 12 of the emission part 11 does not adhere to the edge part of the vapor passage holes 17a of the cooling means 17.

In this embodiment having the above-discussed structural arrangement, when vapor deposition of organic thin film on the substrate 20 is conducted, a predetermined quantity of the vapor 50 of organic evaporation material supplied from the respective feeding means 3a, 3b and 3c and obtained in the respective evaporation chambers 3A, 3B and 3C is guided into the feeding pipe 14 via the inlet pipe 34, as illustrated in Fig. 2 and Fig. 4.

Then, the vapor 50 of organic evaporation material is ejected from each of the blowout orifices 15 of the feeding pipe 14 toward the bottom part 11a of the emission part 11 under heating in the direction of, for example, vertically downward.

As a result, the vapor 50 of organic evaporation material having collided against the bottom part 11a of the emission part 11 is not deposited on the bottom part 11a of the emission part 11 and does not stay there, but is reflected therefrom to fill the emission part 11, so that the vapor 50 is emitted from a plurality of the emission orifices 12 to reach the substrate 20 via the mask 21 afterward.

According to the above-described embodiment, an optimum quantity of the organic evaporation material can be evaporated as needed, so that even when vapor deposition is continuously performed over a long period of time, time-degradation and decomposition of the evaporation material can be prevented.

Particularly in this embodiment, the emission part 11 is heated, and at the same time the vapor 50 of organic evaporation material is sprayed against the bottom part 11a of the emission part 11 from the blowout orifices 15 of the feeding pipe 14, so that the temperature of vapor emitted from the emission part 11 can be controlled without depositing the organic material inside the emission part 11.

Also, according to this embodiment, the feeding pipe 14 is formed in a tube-shape such that the vapor 50 of organic evaporation material is sprayed from the blowout orifices 15 against the wall surface of the bottom part 11a of the emission part 11, so that a small quantity of organic evaporation material can be subsequently supplied in a wide range, thus allowing the vapor 50 of organic evaporation material to uniformly disperse in the emission part 11.

Further, according to the embodiment, as the cooling means 17 is provided in a position on the emission orifice 12 side of the emission part 11 to block the heat transfer from the emission part 11 toward the mask 21 during vapor deposition, deformation of the mask 21 due to heat during the vapor deposition can be prevented.

Specifically, the cooling means 17 is formed so as to cover the entire emission part 11 and also has vapor passage holes 17a allowing the vapor 50 of organic evaporation material to pass therethrough at positions corresponding to the respective emission orifices 12 of the emission part 11, thereby surely preventing the mask 21 from deformation by the heat during vapor deposition while emitting sufficient quantity of the vapor 50 of organic evaporation material for the substrate 20.

Moreover, according to this embodiment, as the emission orifice 12 of the emission part 11 is formed at the tip of the nozzle part 13, and the tip of the nozzle part 13 is disposed in the position inside the vapor passage hole 17a of the cooling means 17, during the vapor deposition, the vapor 50 of organic evaporation material emitted from the emission orifice 12 of the emission part 11 does not adhere to the edge part of the vapor passage hole 17a of the cooling means 17, thus a specified quantity of the vapor 50 of organic evaporation material can be smoothly guided toward the substrate 20.

The present invention is not limited to above-discussed embodiment, therefore various modifications can be made.

For example, the present invention is applicable not only to a vacuum deposition apparatus for forming a light-emitting layer of an organic EL element but also to an apparatus for forming varieties of organic thin films.

Nevertheless, the present invention becomes most effective when applied to an apparatus for forming a light-emitting layer of an organic EL element.

For purposes of uniformity of the film thickness and of enhancement of efficiency in the use of the evaporation material, relative oscillation can be applied between the mask 21 and the substrate 20, and the emission part 11, during the vapor deposition.

Specifically for the above embodiment, for example, it is preferable that the mask 21 and the substrate 20 are oscillated by a driving mechanism 18 as shown in Fig. 2 or Fig. 4 in the direction orthogonal to the extending direction of the main part 14a of the material feeding part 14, (i.e., the direction of Y-axis in Fig. 1). In this way, further uniform film-forming can be attained.

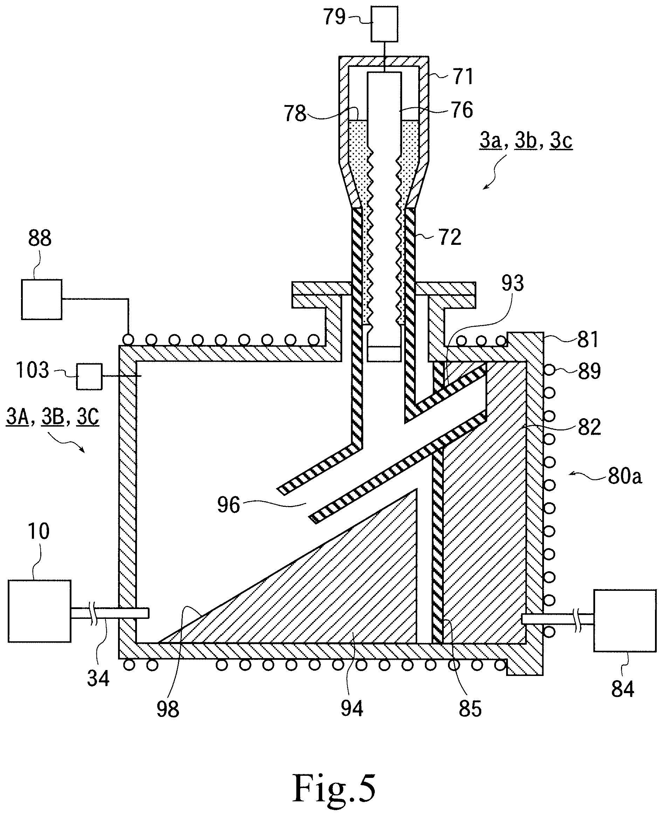

Next, in reference to Fig. 5, an example of the evaporation chamber 3A to 3C and the feeding means 3a to 3c is described below.

A reference number 81 of Fig. 5 denotes a heating tank 81. In this embodiment, the heating tank 81 is divided into two sections by a partition 85, such that one section forms the evaporation chambers 3A to 3C, while the other section forms a gas-heating device 80a.

According to this embodiment, although the heating tank 81 is located outside the vacuum tank 2, it can also be located inside the vacuum tank 2.

Each of the evaporation chambers 3A to 3C has an evaporation device 94 disposed therein. The evaporation device 94 is made of metal, and an evaporation face 98 as the upper surface of the evaporation device 94 is smoothed, and inclined to the horizontal direction by an angle θ(0°<θ< 90°).

A heating filter 82 is disposed inside the gas-heating device 80a. The heating filter 82 formed of a porous SiC; a laminate of reticulated SiC or of metallic wire mesh; or other material which allows to permeat gases and does not decompose or emit gases even when heated to a high temperature.

A heater 89 is disposed on the side faces, bottom face, and top face of the heating tank 81. When electric power is applied by a heating power source 88 to the heater 89 to generate heat, the temperature in the heating tank 81 increases; and the heating filter 82 and the evaporation device 94 are heated by thermal conduction and radiation from the heating tank 81. An induction heating coil may be disposed outside the heating tank 81 in order to conduct induction-heating of the heating filter 82 and the evaporation device 94 by an alternating magnetic field.

Inside the heating tank 81, a connection pipe 93 is disposed so as to extend over a range between the gas-heating device 80a and the evaporation chambers 3A to 3C. The partition 85 is made of a material for not allowing gases to pass therethrough; one end of the connection pipe 93 opens in the evaporation chambers 3A to 3C, while the other end thereof opens in the gas-heating device 80a; and the gas-heating device 80a and the evaporation chambers 3A to 3C are connected to each other by the connection pipe 93, so that the gas inside the gas-heating device 80a can pass through the connection pipe 93 and enter the evaporation chambers 3A to 3C.

As each of the evaporation chambers 3A to 3C is connected to an evacuation system 103, when each of the evaporation chambers 3A to 3C is evacuated to vacuum, the gas in the gas-heating device 80a is also evacuated to vacuum via the connection pipe 93, thus the inside space of the respective evaporation chambers 3A to 3C and the gas-heating device 80a can also be brought to a vacuum atmosphere. When vapor is generated, however, the evaporation chambers 3A to 3C are blocked from the evacuation system 103 so as not to evacuate the generated vapor.

The gas-heating device 80a is connected to a carrier-gas feed system 84. A carrier gas composed of rare gas (such as, Ar and Xe), which does not react with the organic material, is supplied from the carrier-gas feed system 84. (If the vapor of the organic material reacts with nitrogen gas, the nitrogen gas is not suitable for the carrier gas.) When the carrier gas is supplied from the carrier-gas feed system 84 to the gas-heating device 80a, the carrier gas passes through micropores or reticulation of the heating filter 82 to enter the connection pipe 93, then the carrier gas flows through the connection pipe 93 to enter the evaporation chambers 3A to 3C.

Since the heating filter 82 is heated by the heater 89, when the carrier gas passes through the heating filter 82, the carrier gas is heated to a temperature higher than the evaporation temperature of the organic material and lower than the decomposition temperature thereof.

Each of the feeding means 3a to 3c has a tank chamber 71 and a raw-material feeding pipe 72. The tank chamber 71 is located above the evaporation chambers 3A to 3C.

The raw-material feeding pipe 72 is airtightly connected to the lower end of the tank chamber 71 at the upper end thereof, while the lower end thereof is airtightly inserted into the evaporation chambers 3A to 3C. As the internal space of the tank chamber 71 and the internal space of the subjected one of the evaporation chambers 3A to 3C are connected to each other by the raw-material feeding pipe 72, when the internal space of the subjected one of the evaporation chambers 3A to 3C is evacuated to vacuum the internal space of the tank chamber 71 and the internal space of the raw-material feeding pipe 72 are also evacuated to vacuum.

The tank chamber 71 is airtightly closed, so that no atmospheric air enters therein during the evacuation of the tank chamber 71, the raw-material feeding pipe 72, and the evaporation chambers 3A to 3C.

Inside the raw-material feeding pipe 72, a rotary shaft 76 with thread and groove formed on the side face thereof is disposed. In this embodiment, the raw-material feeding pipe 72 and the rotary shaft 76 are vertically arranged.

The thread of the rotary shaft 76 and the inner wall surface of the raw-material feeding pipe 72 contact each other or are close to each other with a small gap therebetween, while the internal space of the tank chamber 71 is connected to the evaporation chambers 3A to 3C by the groove. As the inclination of the thread groove to the horizontal direction is small, in a stationary state of the rotary shaft 76, even if a powder having particles being smaller than the width of the groove is disposed in the tank chamber 71, the powder in the tank chamber 71 does not drop into the evaporation chambers 3A to 3C.

The above-described organic evaporation material 78 is disposed in the tank chamber 71. The organic evaporation material 78 is a powder of mixture of a base material of the organic thin film and a coloring substance. The tank chamber 71 of each of the feeding means 3a to 3c may contain different kind (color) of organic evaporation material 78 from each other, or may contain the same kind of organic evaporation material 78.

A reference symbol 79 in Fig. 5 denotes a rotating means having a motor and so forth. The rotary shaft 76 is connected to the rotating means 79. When the r rotating means 79 is actuated, the rotary shaft 76 rotates around the center axis thereof in the raw-material feeding pipe 72 without ascending and descending.

In a stationary state of the rotary shaft 76, the organic evaporation material 78 in the tank chamber 71 does not move; When, however, the rotary shaft 76 is rotated, the organic evaporation material 78 passes through the groove and enter the inside of the raw-material feeding pipe 72, and then travels downward along the groove of the raw-material feeding pipe 72.

The lower end of the raw-material feeding pipe 72 is inserted in the evaporation chambers 3A to 3C, and is connected to the connection pipe 93 to be configured such that the internal space of the raw-material feeding pipe 72 communicates with the internal space of the connection pipe 93.

As the lower end of the groove is opened in the raw-material feeding pipe 72, the organic evaporation material 78 having moved downward by the rotation of the rotary shaft 76 and having reached the lower end of the groove falls down from the groove onto the inner peripheral surface of the connection pipe 93.

When rotating the rotary shaft 76 at a lower rate, since there is a one-to-one relationship between a traveling amount of the organic evaporation material 78 in the groove and a rotation amount of the rotary shaft 76, if the relationship between the amounts of rotation and the falling of the organic evaporation material 78 is determined in advance, a desired amount of the organic evaporation material 78 can be allowed to fall from the raw-material feeding pipe 72. Rotation at a lower rate can subsequently let the organic evaporation material 78 fall by small amounts.

A portion of the connection pipe 93 between the end part inside the evaporation chambers 3A to 3C and a position where the organic evaporation material 78 falls is inclined such that an opening 96 as the end part is located below the level of the falling position. Therefore, the organic evaporation material 78 that has fallen on the inner peripheral surface of the connection pipe 93 slides down on the inner peripheral surface of the connection pipe 93 toward the opening 96.

The opening 96 is located directly above the evaporation surface 98 of the evaporation device 94, so that the organic evaporation material 78 having reached the opening 96 falls down onto the evaporation surface 98 from the opening 96.

The organic evaporation material 78 having dropped onto the evaporation surface 98 is spread on the evaporation surface 98. Since the evaporation surface 98 is inclined, the organic evaporation material 78 slides down on the evaporation surface 98 in a spreading state.
Although the organic evaporation material 78 that falls onto the evaporation surface 98 is powder at room temperature, the organic evaporation material 78 evaporates when heated to or above the evaporation temperature thereof to become the vapor 50 of organic evaporation material. The evaporation device 94 is heated by the heater 89 in advance to a temperature higher than the evaporation temperature of the organic evaporation material 78; and the organic evaporation material 78 of an amount that is able to completely evaporate before sliding down to reach the lower end of the evaporation surface 98(i.e., during the sliding)is supplied, so that the organic evaporation material 78 begins to evaporate immediately after being spread on the evaporation surface 98, and evaporates while sliding down, and then vanishes from the evaporation surface 98 without reaching the lower end thereof.

When dropping the organic evaporation material 78 onto the evaporation surface 98, although the evacuation of the vacuum tank is conducted, the valves between the evaporation chambers 3A to 3C and the evacuation system 103 are kept closed in order to prevent evacuation of the vapor 50 of organic evaporation material, generated in the evaporation chambers 3A to 3C by the evaporation of the organic evaporation material 78, without passing through the feeding pipe 14.

The evaporation chambers 3A to 3C and the feeding pipe 14 are connected to each other by the inlet pipe 34. When dropping the organic evaporation material 78 onto the evaporation surface 98, the carrier gas is supplied to the gas-heating device 80a before the falling of the material 78 begins, so as to guide the heated carrier gas to the evaporation chambers 3A to 3C.

The opening 96 of the connection pipe 93 through which the heated carrier gas flows is directed to a portion of the evaporation surface 98 where the organic evaporation material 78 evaporates in order to spray the heated carrier gas toward such portion, so that the vapor 50 of organic evaporation material and the heated carrier gas are uniformly mixed together in the evaporation chambers 3A to 3C; and the mixed gas enters the vapor emission device 10 via the inlet pipe 34.

By controlling the flow rate of the carrier gas being supplied from the carrier-gas feed system 84 to the gas-heating device 80a, the internal pressure of the feeding pipe 14 is regulated to a magnitude for forming a viscous flow of the mixed gas (a mixed gas of the carrier gas and the organic material vapor) in the feeding pipe 14, so that the inside space of each of the main bodies 14a of the feeding pipe 14 is filled with the mixed gas having almost equal pressure over a range from the root to the front end thereof.

Inside the vacuum tank 2 is directly evacuated in a continuous manner; and the surrounding pressure of the feeding pipe 14 is lower than the internal pressure of the feeding pipe 14. As a result, the mixed gas is emitted from blowout orifices 15 at an equal flow rate, so that the vapor 50 of organic evaporation material passes through the vapor passage holes 17a of the cooling means 17 and the penetration holes on the mask 21 in order to reach the surface of substrate 20 with a uniform density per unit surface area thereof.

Even when the amount of the vapor 50 of organic evaporation material that enters is small, the introduction of the carrier gas can bring the internal pressure of the feeding pipe 14 to a level which can uniformly emit the vapor from the blowout orifices 15 over the range from the front end to the root of the main body 14a.

Also, when the amount of generation of the vapor 50 of organic evaporation material varies, the internal pressure of the feeding pipe 14 can be adjusted by changing the entering amount of the carrier gas. Consequently, it is possible to change the amount of generation of the vapor 50 of organic evaporation material. In other words, it is consequently possible to adjust the film-forming rate.

Since the organic material vapor reaches the surface of substrate over the range from the root to the front end of each main body 14a in an equal amount, an organic thin film without unevenness can be obtained.

## Claims

1. A vapor emission device, comprising:
an emission part in the shape of a shower-plate (11) configured so as to be heatable and having a plurality of emission orifices (12) arranged within a plane thereof for emitting a vapor of an organic evaporation material (50);
a feeding part (14) provided inside the emission part (11) to feed the vapor of the organic evaporation material (50) thereinto, and having a blowout orifice (15) configured so as to spray the vapor of the organic evaporation material (50) against an inner wall (11a) of the emission part (11); and
a cooling means (17) provided at least in a position on the emission orifice (12) side of the emission part (11), wherein the cooling means (17) is formed so as to cover the entire emission part (11).

2. The vapor emission device according to claim 1, wherein the emission part (11) comprises a plurality of truncated-cone-shaped nozzle parts (13) provided in the upper part of the emission part (11) and the cooling means (17) has a plurality of vapor passage holes (17a), wherein the tip of each of the nozzle parts (13) is disposed in a position inside each of the vapor passage holes (17a) of the cooling means (17), and where the tip of the nozzle parts (13) does not protrude from each of the vapor passage holes (17a).

3. The vapor emission device according to claim 2, wherein the vapor passage holes (17a) are in a position corresponding to the emission orifices (12) of the emission part (11), allowing the vapor of the organic evaporation material (50) to pass therethrough,

4. The vapor emission device according to claim 3, wherein the emission orifices (12) of the emission part (11) are formed at the tip of the nozzle parts (13), and the tip of the nozzle parts (13) are located in a position inside the vapor passage hole (17a) of the cooling means (17).

5. An organic thin-film vapor deposition apparatus, which deposits an organic thin film to a vapor deposition object (20) in a vacuum via a mask (21), the apparatus, comprising:
a vacuum tank (2) for deposition, which carries the vapor deposition object (20) thereinto; and
a vapor emission device (10) provided in the vacuum tank (2), the vapor emission device including:
an emission part in the shape of a shower-plate (11) configured so as to be heatable and having a plurality of emission orifices (12) arranged within a plane thereof for emitting a vapor of an organic evaporation material (50);
a feeding part (14) provided inside the emission part (11) for feeding the vapor of the organic evaporation material (50) thereinto, and having a blowout orifice (15) configured so as to spray the vapor of the organic evaporation material (50) against an inner wall (11a) of the emission part (11); and
a cooling means (17) provided at least in a position on the emission orifice (12) side of the emission part (11),
wherein the emission orifices (12) of the emission part (11) are arranged so as to face the mask (21), and wherein the cooling means (17) is formed so as to cover the entire emission part (11).

6. A method for depositing organic thin film which deposits an organic thin film to a vapor deposition object (20) in a vacuum via a mask (21), the method, comprising the step of:
feeding an evaporation material, with the use of an emission part in the shape of a shower-plate (11) having a plurality of emission orifices (12) arranged within a plane thereof, by spraying a vapor of an organic evaporation material (50) in the emission part (11) against an inner wall (11a) thereof while heating the emission part (11),
wherein heat transfer from the emission part (11) toward the mask (21) is blocked by interposing a cooling means (17) between the emission part (11) and the mask (21) in the step of feeding an evaporation material (50), the cooling means (17) being formed so as to cover the entire emission part (11).

## Patentansprüche

1. Dampfemissionsvorrichtung, aufweisend:
ein Emissionsteil in der Form einer Duschplatte (11), welches so konfiguriert ist, dass sie beheizbar ist und eine Vielzahl von Emissionsöffnungen (12) aufweist, die in einer Ebene angeordnet sind, um hieraus einen Dampf eines organischen Verdampfungsmaterials (50) zu emittieren;
ein Zuführteil (14), das innerhalb des Emissionsteils (11) angeordnet ist, um den Dampf des organischen Verdampfungsmaterials (50) dorthin einzuleiten, und eine Ausblasöffnung (15), die so konfiguriert ist, dass sie den Dampf des organischen Verdampfungsmaterials (50) gegen eine Innenwand (11a) des Emissionsteils (11) bläst; und
eine Kühleinrichtung (17), die zumindest in einer Position auf der Seite der Emissionsöffnung (12) des Emissionsteils (11) vorgesehen ist, wobei die Kühleinrichtung (17) so ausgebildet ist, dass sie das gesamte Emissionsteil (11) abdeckt.

2. Dampfemissionsvorrichtung nach Anspruch 1, wobei das Emissionsteil (11) eine Mehrzahl von kegelstumpfförmigen Düsenteilen (13) umfasst, die im oberen Teil des Emissionsteils (11) und der Kühleinrichtung (17) vorgesehen sind, und eine Mehrzahl von Dampfdurchtrittslöchern (17a), wobei die Spitze von jedem der Düsenteile (13) in einer Position innerhalb jedes der Dampfdurchtrittslöcher (17a) der Kühleinrichtung (17) angeordnet ist, und wobei die Spitze der Düsenteile (13) nicht aus jedem der Dampfdurchtrittslöcher (17a) hervorsteht.

3. Dampfemissionsvorrichtung nach Anspruch 2, wobei sich die Dampfdurchtrittslöcher (17a) in einer Position befinden, die der der Emissionsöffnungen (12) des Emissionsteils (11) entspricht, wodurch es dem Dampf des organischen Verdampfungsmaterials (50) ermöglicht wird durch sie hindurchzutreten.

4. Dampfemissionsvorrichtung nach Anspruch 3, wobei die Emissionsöffnungen (12) des Emissionsteils (11) an der Spitze der Düsenteile (13) ausgebildet sind und die Spitze der Düsenteile (13) an einer Position innerhalb des Dampfdurchgangslochs (17a) der Kühleinrichtung (17) angeordnet ist.

5. Organische Dünnfilm-Bedampfungsvorrichtung, die im Vakuum über einer Maske (21) auf ein Bedampfungsobjekt (20) einen organischen Dünnfilm abscheidet, wobei die Vorrichtung aufweist:
einen Vakuumtank (2) zur Bedampfung, der das Bedampfungsobjekt (20) in sich trägt; und
eine Dampfemissionsvorrichtung (10), die in dem Vakuumtank (2) vorgesehen ist, wobei die Dampfemissionsvorrichtung umfasst:
ein Emissionsteil in der Form einer Duschplatte (11), die so konfiguriert ist, dass sie beheizbar ist und eine Vielzahl von in einer Ebene angeordneten Emissionsöffnungen (12) aufweist, um einen Dampf eines organischen Verdampfungsmaterials (50) zu emittieren;
ein Zuführteil (14), das innerhalb des Emissionsteils (11) zum Einführen des Dampfes des organischen Verdampfungsmaterials (50) vorgesehen ist und eine Ausblasöffnung (15) aufweist, die so konfiguriert ist, dass sie den Dampf des organischen Verdampfungsmaterials (50) gegen eine Innenwand (11a) des Emissionsteils (11) bläst; und
eine Kühleinrichtung (17), die zumindest in einer Position auf der Seite der Emissionsöffnung (12) des Emissionsteils (11) vorgesehen ist,
wobei die Emissionsöffnungen (12) des Emissionsteils (11) so angeordnet sind, dass sie der Maske (21) zugewandt sind, und wobei die Kühleinrichtung (17) so ausgebildet ist, dass sie den gesamten Emissionsteil (11) bedeckt.

6. Verfahren zum Abscheiden eines organischen Dünnfilms, der einen organischen Dünnfilm über eine Maske (21) in einem Bedampfungsobjekt (20) im Vakuum abscheidet, wobei das Verfahren den folgenden Schritt umfasst:
Zuführen eines Verdampfungsmaterials unter Verwendung eines Emissionsteils in Form einer Duschplatte (11) mit einer Mehrzahl von in einer Ebene angeordneten Emissionsöffnungen (12) durch Sprühen eines Dampfes eines organischen Verdampfungsmaterials (50) in dem Emissionsteil (11) gegen eine innere Wand (11a) desselben, während das Emissionsteil (11) erhitzt wird,
wobei die Wärmeübertragung von dem Emissionsteil (11) auf die Maske (21) blockiert wird, indem bei dem Schritt des Zuführens eines Verdampfungsmaterials (50) eine Kühleinrichtung (17) zwischen dem Emissionsteil (11) und der Maske (21) angeordnet wird, wobei die Kühleinrichtung (17) so ausgebildet ist, dass sie das gesamte Emissionsteil (11) bedeckt.

## Revendications

1. Dispositif d'émission de vapeur, comprenant :
une partie d'émission ayant la forme d'une plaque de douche (11) configurée de manière à pouvoir être chauffée et ayant une pluralité d'orifices d'émission (12) disposés dans un plan de celle-ci pour émettre une vapeur d'un matériau d'évaporation organique (50) ;
une partie d'alimentation (14) fournie à l'intérieur de la partie d'émission (11) pour y alimenter la vapeur du matériau d'évaporation organique (50), et ayant un orifice d'éjection (15) configuré afin de pulvériser la vapeur du matériau d'évaporation organique (50) contre une paroi intérieure (11a) de la partie d'émission (11) ; et
un moyen de refroidissement (17) fourni au moins dans une position du côté de l'orifice d'émission (12) de la partie d'émission (11), dans lequel le moyen de refroidissement (17) est formé de manière à recouvrir toute la partie d'émission (11).

2. Dispositif d'émission de vapeur selon la revendication 1, dans lequel la partie d'émission (11) comprend une pluralité de parties de buse en forme de cône tronqué (13) fournies dans la partie supérieure de la partie d'émission (11) et le moyen de refroidissement (17) comprend une pluralité de trous de passage de vapeur (17a), dans lequel la pointe de chacune des parties de buse (13) est disposée dans une position à l'intérieur de chacun des trous de passage de vapeur (17a) du moyen de refroidissement (17), et où la pointe des parties de buse (13) ne dépasse pas à partir de chacun des trous de passage de vapeur (17a).

3. Dispositif d'émission de vapeur selon la revendication 2, dans lequel les trous de passage de vapeur (17a) sont dans une position correspondant aux orifices d'émission (12) de la partie d'émission (11), permettant à la vapeur du matériau d'évaporation organique (50) de passer à travers ceux-ci.

4. Dispositif d'émission de vapeur selon la revendication 3, dans lequel les orifices d'émission (12) de la partie d'émission (11) sont formés à la pointe des parties de buse (13), et la pointe des parties de buse (13) est située dans une position à l'intérieur du trou de passage de vapeur (17a) du moyen de refroidissement (17).

5. Appareil de dépôt en phase vapeur de film mince organique, qui dépose un film mince organique sur un objet de dépôt en phase vapeur (20) dans un vide via un masque (21), l'appareil comprenant :
un réservoir de vide (2) pour le dépôt, qui transporte l'objet de dépôt en phase vapeur (20) ; et
un dispositif d'émission de vapeur (10) fourni dans le réservoir de vide (2), le dispositif d'émission de vapeur comprenant :
une partie d'émission ayant la forme d'une plaque de douche (11) configurée de manière à pouvoir être chauffée et ayant une pluralité d'orifices d'émission (12) disposés dans un plan de celle-ci pour émettre de la vapeur d'un matériau d'évaporation organique (50) ;
une partie d'alimentation (14) fournie à l'intérieur de la partie d'émission (11) pour alimenter la vapeur du matériau d'évaporation organique (50), et ayant un orifice d'éjection (15) configuré afin de pulvériser la vapeur du matériau d'évaporation (50) contre une paroi intérieure (11a) de la partie d'émission (11),
un moyen de refroidissement (17) fourni au moins dans une position du côté de l'orifice d'émission (12) de la partie d'émission,
dans lequel les orifices d'émission (12) de la partie d'émission (11) sont agencés de manière à faire face au masque (21), et dans lequel le moyen de refroidissement (17) est formé de manière à recouvrir toute la partie d'émission (11).

6. Procédé de dépôt d'un film mince organique, qui dépose un film mince organique sur un objet de dépôt en phase vapeur (20) dans un vide via un masque (21), le procédé comprenant l'étape consistant à :
alimenter un matériau d'évaporation, avec l'utilisation d'une partie d'émission en forme de plaque de douche (11) ayant une pluralité d'orifices d'émission (12) disposés dans un plan de celle-ci, en pulvérisant une vapeur d'un matériau d'évaporation organique (50) dans la partie d'émission (11) contre une paroi intérieure (11a) de celle-ci tout en chauffant la partie d'émission (11),
dans lequel un transfert de chaleur de la partie d'émission (11) vers le masque (21) est bloqué en interposant un moyen de refroidissement (17) entre la partie d'émission (11) et le masque (21) dans l'étape consistant à alimenter un matériau d'évaporation (50), le moyen de refroidissement (17) étant formé de manière à recouvrir toute la partie d'émission (11).
